# EUROPÄISCHE PATENTSCHRIFT

(11) **EP 1 374 332 B1**
(45) Veröffentlichungstag und Bekanntmachung des Hinweises auf die Patenterteilung: **09.11.2005**
(21) Anmeldenummer: 02716781.6
(22) Anmeldetag: 15.02.2002
(51) Int. Cl.: H01M 10/50, H01M 2/10, H05K 7/20

(54) **GEHÄUSE ZUR AUFNAHME MINDESTENS EINER ENERGIESPEICHEREINRICHTUNG**
HOUSING FOR ACCOMMODATING AT LEAST ONE ENERGY ACCUMULATOR DEVICE
BOITIER DESTINE A CONTENIR AU MOINS UN DISPOSITIF D'ACCUMULATION D'ENERGIE

(30) Priorität: 27.03.2001 DE 10114960
(43) Veröffentlichungstag der Anmeldung: 02.01.2004
(73) Patentinhaber: Knürr AG, 94424 Arnstorf (DE)
(72) Erfinder: EBERMANN, Heiko, 01109 Dresden (DE)
(74) Vertreter: Heim, Hans-Karl
(86) Internationale Anmeldenummer: PCT/EP2002/001615
(87) Internationale Veröffentlichungsnummer: WO 2002/078414

(56) Entgegenhaltungen:
- US-A- 4 314 008
- US-A- 6 123 266
- US-B1- 6 294 721

## Beschreibung

Die Erfindung betrifft ein Gehäuse zur Aufnahme mindestens einer Energiespeichereinrichtung nach dem Oberbegriff des Anspruchs 1.

Ein Gehäuse der eingangs genannten Art ist bekannt und dient insbesondere als Batterieschrank zur Aufnahme von Batterien und/oder wiederaufladbaren Akkumulatoren als Energiespeichereinrichtung. Derartige Energiespeichereinrichtungen bzw. Elektroenergiespeichereinrichtungen, insbesondere Hochleistungsbatterien und Hochleistungsakkumulatoren, zeichnen sich dadurch aus, dass sie innerhalb eines vorgegebenen Betriebstemperaturbereiches betrieben werden müssen, damit sie bei maximaler Lebensdauer eine maximale Speicherkapazität bzw. Speicherfähigkeit besitzen. Eine dauernde Temperaturerhöhung gegenüber diesem vorgegebenen Betriebstemperaturbereich führt bei derartigen Energiespeichereinrichtungen zu einer deutlichen Verkürzung der Lebenszeit der Energiespeichereinrichtung, während ein Betrieb der Energiespeichereinrichtung unterhalb dieses vorgegebenen Betriebstemperaturbereiches zu einer deutlichen Verringerung der Speicherkapazität der Energiespeichereinrichtung führt.

Insbesondere wenn das Gehäuse zur Aufnahme der Energiespeichereinrichtung im Freien angeordnet ist, besteht das Problem dass die Temperatur im Gehäuseinnenraum in Abhängigkeit von der Umgebungstemperatur schwankt, so dass die Energiespeichereinrichtung nicht in dem optimalen Betriebstemperaturbereich betrieben werden kann. Um dies zu vermeiden ist es bekannt, die Temperatur im Gehäuseinnenraum mit Hilfe einer Wärmetransfereinrichtung auf einen vorgegebenen Temperaturbereich zu regeln.

So offenbart die DE 200 07 930 U1 eine Belüftungsvorrichtung für ein Gehäuse, in dem elektrische und elektronische Bauteile angeordnet sind. Mit Hilfe der Belüftungsvorrichtung wird ein interner Luftstrom aus dem Gehäuseinnenraum abgesaugt, durch einen aus der Umgebung angesaugten externen Luftstrom gekühlt bzw. erwärmt und nach der Temperaturangleichung wieder in den Gehäuseinnenraum zurückgefördert. Zusätzlich ist in der Belüftungsvorrichtung eine Wärmetransfereinrichtung vorgesehen, die so angeordnet ist, dass mit ihr Wärme wahlweise aktiv vom internen an den externen Luftstrom oder vom externen an den internen Luftstrom übertragen werden kann. Bei dieser bekannten Belüftungsvorrichtung besteht nun das Problem, dass Luft eine vergleichsweise geringe Wärmekapazität besitzt, so dass insbesondere bei einer plötzlichen Temperaturänderung im Gehäuseinnenraum die Temperatur im Gehäuseinnenraum trotz Verwendung der Wärmetransfereinrichtung erst langsam wieder auf den vorgegebenen Temperaturbereich zurückgeführt werden kann.

Aus der DE 298 20 993 U1 ist eine Vorrichtung zum Austausch von Wärmeenergie zwischen dem Innenraum eines Gehäuses und der Umgebung des Gehäuses bekannt. Diese bekannte Vorrichtung weist einen Wärmetauscherblock mit zwei voneinander getrennten und miteinander in Wärmeenergie übertragendem Kontakt stehenden Fluidleitungssystemen auf, wobei das erste Fluidleitungssystem mit dem Gehäuseinnenraum und das zweite Fluidleitungssystem mit der Umgebung verbunden ist. Da die beiden Fluidleitungssysteme getrennt voneinander ausgebildet sein müssen, ist diese bekannte Vorrichtung vergleichsweise aufwendig ausgebildet. Darüber hinaus gilt auch hier, dass die Wärmekapazität des Fluids im Fluidleitungssystem gering ist, so dass auch bei dieser bekannten Vorrichtung die Temperatur im Gehäuseinnenraum bei einer plötzlichen Temperaturänderung vergleichsweise langsam wieder auf: den vorgegebenen Temperaturbereich eingeregelt werden kann.

In der US 61 23 266 A ist ein Kühlsystem für Outdoor-Batterieschränke beschrieben. Eine Luftströmung durch den Schrankinnenraum mit übereinander angeordneten Batteriereihen wird durch eine Lufteintrittsöffnung im oberen Bereich einer Gehäusewand und durch eine Luftaustrittsöffnung in einem unteren Bereich dieser Gehäusewand mit Hilfe wenigstens eines Ventilators erreicht. Die Batteriereihen sind auf versetzt angeordneten und mit Luftdurchtrittsöffnungen versehenen Fachböden angeordnet und der gesamte Batterieschrank ist mit einer innenseitigen Isolation versehen. Mit Hilfe einer Regeleinrichtung wird der Ventilator zur Erzeugung einer Luftströmung eingeschaltet, sobald die Außentemperatur geringer als die Temperatur im Schrankinnenraum ist. Bei einer höheren Außentemperatur wird der Ventilator nicht in Betrieb genommen, um die niedrigere Schrankinnentemperatur zu halten. Für relativ große Temperaturschwankungen ist das bekannte Belüftungssystem nicht geeignet.

Ein temperaturstabilisiertes Batteriesystem ist aus der US 43 14 008 bekannt. Eine Batterieeinheit ist von einem wärmeleitfähigen Material, insbesondere Aluminiumfolie, umgeben und in einer Umhüllung aus wärmeisolierendem Material, beispielsweise Polyurethanschaum, angeordnet. Eine Längsseite der Batterieeinheit ist über einen wärmeleitenden Block mit einer Wärmepumpe aus Peltierelementen mit einer Wärmesenke verbunden, um den für einen reibungslosen Batteriebetrieb erforderlichen Temperaturbereich zu halten. Die Wärmesenke ist wesentlich größer als die Batterieeinheit dimensioniert und weist eine außenseitige Berippung auf. Die Temperaturstabilisierung der US 43 14 008 ist nur für relativ kleine Gehäuse geeignet und zudem relativ aufwendig in Konstruktion und Montage.

Es ist **Aufgabe** der Erfindung, ein Gehäuse zur Aufnahme mindestens einer Energiespeichereinrichtung anzugeben, bei dem der Gehäuseinnenraum auch bei großen Temperaturschwankungen außerhalb des Gehäuses ohne großen Aufwand in einem vorgegebenen Temperaturbereich gehalten werden kann. Die Erfindung löst die Aufgabe durch ein Gehäuse mit den Merkmalen nach Anspruch 1.

Gemäß der Erfindung weist ein Gehäuse zur Aufnahme wenigstens einer Energiespeichereinrichtung, insbesondere ein Batterieschrank, mit wenigstens einer Wärmetransfereinrichtung zur Temperaturregelung eines Gehäuseinnenraums auf ein vorgegebenes Temperaturniveau, bei welchem der Gehäuseinnenraum wärmeisoliert ist, die Wärmetransfereinrichtung in direkter Wärmeleitverbindung mit dem Gehäuseinnenraum steht und bei geschlossenem Gehäuseinnenraum nahezu der gesamte Wärmestrom in den und aus dem Gehäuseinnenraum durch die Wärmetransfereinrichtung erfolgt sowie im Bereich einer Gehäusewand ein Wärmetauscher vorgesehen ist, welcher mit der Wärmetransfereinrichtung wärmeleitend verbunden ist, einen Nadelripppenrekuperator auf, der in einem Strömungskanal des Wärmetauschers für ein Kühlmedium, insbesondere Luft, angeordnet ist. Erfindungsgemäß ist wenigstens eine Fördereinrichtung für das Kühlmedium des Strömungskanals vorgesehen.

Um die bei einem Erwärmen des Gehäuseinnenraums von der Wärmetransfereinrichtung aufgenommene Wärme möglichst schnell an die Umgebung des Gehäuses abgeben zu können, ist die Wärmetransfereinrichtung mit dem beispielsweise an einer Gehäuseaußenseite vorgesehenen Wärmetauscher wärmeleitend verbunden und ein Wärmetauscher mit mindestens einem Strömungskanal angeordnet, durch den ein-Kühlmedium zum Kühlen der Wärmetransfereinrichtung förderbar ist. Als Kühlmedium eignet sich beispielsweise ein Gas, vorzugsweise Luft, das durch den Strömungskanal gefördert wird. Alternativ kann zum Kühlen der Wärmetransfereinrichtung auch eine Flüssigkeit mit hoher spezifischer Wärmekapazität wie beispielsweise Wasser verwendet werden.

Es ist vorteilhaft, dass der Wärmetauscher einen mit der Wärmetransfereinrichtung wärmeleitend, in Verbindung stehenden Nadelrippenrekuperator aufweist, welcher aufgrund seiner Nadelrippenstruktur eine sehr große Außenoberfläche besitzt, mit der die vom Nadelrippenrekuperator aufgenommene Wärme an die Umgebung durch Konvektion schnell abgestrahlt werden kann. Der Nadelrippenrekuperator ist vorzugsweise in die Gehäusewand, beispielsweise die Rückwand des Gehäuses, integriert, wodurch sich eine besonders kompakte Bauweise verglichen mit einer zum Gehäuse separaten Ausbildung des Nadelrippenrekuperators ergibt.

Indem der Wärmetauscher zum Fördern des Kühlmediums durch den Strömungskanal wenigstens eine Fördereinrichtung aufweist, kann beispielsweise in Abhängigkeit von der vom Wärmetauscher abzuführenden Wärmemenge die Menge des durch den Strömungskanal zu fördernden Kühlmediums gezielt reguliert werden. Wird als Kühlmedium Luft verwendet, wird insbesondere die Verwendung eines oder mehrerer Axialstromlüfter vorgeschlagen, da Axialstromlüfter bezogen auf ihre Baugröße eine, verglichen mit anderen Lüftern, besonders hohe Förderleistung besitzen. Die Anzahl der Axialstromlüfter hängt insbesondere von der abzuführenden Wärmemenge und den Umgebungsbedingungen ab.

Es ist vorteilhaft, dass die Fördereinrichtung ausgeschaltet werden kann, wenn die Wärmetransfereinrichtung den Gehäuseinnenraum erwärmt, wodurch sich eine besonders hohe Heizleistung der Wärmetransfereinrichtung ergibt, ohne dass ein Teil der von der Wärmetransfereinrichtung abgegebenen Wärmemenge unerwünscht von dem durch die Fördereinrichtung geförderten Kühlmedium abgeführt wird.

Durch den wärmeisolierten Gehäuseinnenraum bestehen keine unerwünschten Wärmebrücken und ein Wärmetransfer zwischen dem Gehäuseinnenraum und der Umgebung des Gehäuses tritt allenfalls äußerst zeitverzögert auf. Andererseits wird bei der Erfindung ein gezielter und schneller Wärmetransfer in den und aus dem Gehäuseinnenraum ermöglicht, indem als einzige zulässige Wärmebrücke zwischen dem wärmeisolierten Gehäuseinnenraum und der Umgebung des Gehäuses die Wärmetransfereinrichtung und eine wärmeleitend verbundene: Wärmetauschereinrichtung mit einem Nadelrippenkuperator in einem Strömungskanal für ein Kühlmedium an einer Gehäusewand vorgesehen ist, wodurch nahezu der gesamte Wärmestrom in den und aus dem Gehäuseinnenraum besonders schnell und effektiv sowie geregelt übertragen wird.

Damit ein eventuell notwendiger Wärmetransfer möglichst schnell erfolgt, ist es zweckmäßig, die Wärmetransfereinrichtung mit dem Gehäuseinnenraum direkt wärmeleitend zu verbinden, d.h., dass die den Gehäuseinnenraum bildenden Materialien des Gehäuses in direkter Wärmeleitverbindung mit der Wärmetransfereinrichtung stehen. Auf diese Weise ist es möglich, dass durch die Materialien im Gehäuseinnenraum, die mit der Wärmetransfereinrichtung wärmeleitend verbunden sind, die Wärme bei einem gewollten Wärmetransfer in den und aus dem Gehäuseinnenraum schnell abgeführt bzw. zugeführt werden kann.

Weitere vorteilhafte Weiterbildungen der Erfindung ergeben sich aus der nachfolgenden Beschreibung, den Unteransprüchen sowie der Zeichnung.

Es ist vorteilhaft, dass bei dem erfindungsgemäßen Gehäuse Wärmebrücken zwischen dem Gehäuseinnenraum und der Umgebung des Gehäuses vermieden werden und der Gehäuseinnenraum von der Umgebung des Gehäuses thermisch entkoppelt ist.

Bei einer besonders bevorzugten Ausführungsform des Gehäuses wird vorgeschlagen, die Wärmetransfereinrichtung in der Isolierung des Gehäuses anzuordnen, so dass auch die Wärmetransfereinrichtung allenfalls geringen Temperaturschwankungen ausgesetzt ist, wodurch eine besonders genaue Temperaturregelung des Gehäuseinnenraums auf das vorgegebene Temperaturniveau möglich wird.

Besonders vorteilhaft ist es, wenn die Wärmetransfereinrichtung mit einem im Gehäuseinnenraum vorgesehenen Rahmen wärmeleitend verbunden ist, auf den die Energiespeichereinrichtung anzuordnen ist. Durch Verwendung des mit der Wärmetransfereinrichtung wärmeleitend gekoppelten Rahmens ist es möglich, insbesondere die während des Ladens der Energiespeichereinrichtung in ihr entstehende Wärme mit Hilfe des Rahmens schnell und direkt an die Wärmetransfereinrichtung abzuführen, welche ihrerseits die aufgenommene Wärme schnell an die Umgebung des Gehäuses abgibt. Durch die schnelle Wärmeabfuhr wird erreicht, dass die sich erwärmende Energiespeichereinrichtung allenfalls geringe Wärmemengen durch Konvektion an den Gehäuseinnenraum abgibt, so dass sich der Gehäuseinnenraum bei einem Laden der Energiespeicher-einrichtung allenfalls geringfügig erwärmt.

Des Weiteren wird vorgeschlagen, die Wärmetransfereinrichtung mit Hilfe eines Wärmeübertragungselementes mit dem Gehäuseinnenraum wärmeleitend zu verbinden, so dass die Wärmetransfereinrichtung beabstandet zum Gehäuseinnenraum angeordnet werden kann.

Wenn die Wärmetransfereinrichtung in der Isolierung des Gehäuses angeordnet ist, kann die Wärmetransfereinrichtung durch ein weiteres Wärmeübertragungselement mit dem Wärmetauscher zur Wärmeübertragung wärmeleitend verbunden sein.

Die Wärmeübertragungselemente, mit denen die Wärmetransfereinrichtung mit dem Gehäuseinnenraum und mit dem Wärmetauscher verbunden ist, weisen bei einer besonders bevorzugten Ausführungsform der Erfindung eine vergleichsweise hohe Wärmeleitfähigkeit λ auf. Als Werkstoff hierzu eignet sich beispielsweise Aluminium mit einer Wärmeleitfähigkeit von 220 W/mK, Magnesium mit einer Wärmeleitfähigkeit von 171 W/mK, auch Kupfer mit einer Wärmeleitfähigkeit von 384 W/mK oder Legierungen aus Metallen mit ähnlich hohen Wärmeleitfähigkeiten.

Wird das Gehäuse für eine Energiespeichereinrichtung mit vergleichsweise hoher Speicherkapazität verwendet, wird bei einer bevorzugten Ausführungsform des Gehäuses vorgeschlagen, im Gehäuse mehrere Ebenen zur Aufnahme der Energiespeichereinrichtung auszubilden. Um einen entsprechend schnellen Wärmetransfer zwischen dem Gehäuseinnenraum und der Umgebung des Gehäuses zu gewährleisten, wird bei dieser Ausführungsf:orm ferner vorgeschlagen, jeder Ebene mindestens eine: Wärmetransfereinrichtung zuzuordnen, so dass auch beispielsweise bei einer unterschiedlichen Erwärmung jeder Ebene im Gehäuseinnenraum die entstehende Wärmemenge selektiv bezogen auf die jeweilige Ebene von der betreffenden Wärmetransfereinrichtung abgeführt bzw. zugeführt werden kann. Alternativ ist es auch möglich, die verschiedenen Ebenen durch ein gemeinsames Wärmeübertragungsglied mit einer oder mehreren Wärmetransfereinrichtungen thermisch zu koppeln.

Als Wärmetransfereinrichtung wird vorzugsweise ein Peltierelement verwendet, mit dem in Abhängigkeit von der angelegten Stromrichtung schnell und problemlos ein Wärmestrom aus dem Gehäuseinneren abgeführt oder dem Gehäuseinneren zugeführt werden kann. In diesem Zusammenhang wird als Peltierelement eine aus einer oder mehreren Peltiereinheiten zusammengesetzte Anordnung verstanden.

Nachfolgend wird die Erfindung anhand eines Ausführungsbeispieles unter Bezugnahme auf die Zeichnung näher erläutert. Darin zeigen:
- Fig. 1: eine Seitenansicht eines erfindungsgemäßen Gehäuses, bei dem die Seitenverkleidung weggelassen wurde; und
- Fig. 2: eine Vorderansicht des Gehäuses nach Fig. 1, in der die Frontseite des Gehäuses geöffnet dargestellt ist.

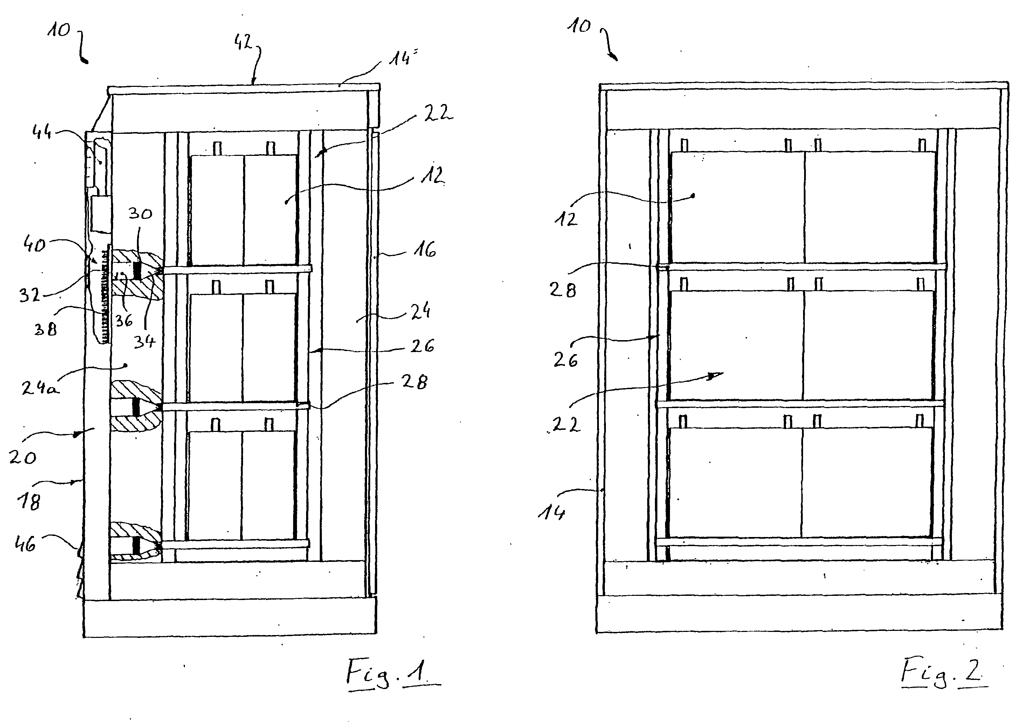

In den Fig. 1 und 2 ist ein als Batterieschrank ausgebildetes Gehäuse 10 dargestellt, in dem auf insgesamt drei Aufnahmeebenen 28 als Energiespeichereinrichtung 12 zwölf Akkumulatoren 12 angeordnet sind. Die Akkumulatoren 12 sind an nicht dargestellte Leitungen angeschlossen, die aus dem Gehäuse 10 führen. Das in den Fig. 1 und 2 gezeigte Gehäuse 10 ist insbesondere im Freien aufgestellt und dient dort beispielsweise zur vorläufigen oder auch ständigen Spannungsversorgung von beispielsweise Telekommunikationseinrichtungen, Sendemasten und ähnlichem.

Die Vorderseite des Gehäuses 10 mit Seitenwänden 14 und einer Rückwand 18 ist durch eine schwenkbare Tür 16 (vgl. Fig. 1) verschlossen, die aus Übersichtlichkeitsgründen in Fig. 2 nicht dargestellt ist. Im Bereich der Rückwand 18 des Gehäuses 10 ist ein Wärmetauscher 20 angeordnet, dessen Aufbau später noch erläutert wird. In Fig. 1 wurde aus Darstellungsgründen die in Fig. 2 links angeordnete Seitenverkleidung weggelassen.

Der Innenraum 22 des Gehäuses 10 ist durch eine Isolierung 24, z.B. Isolationseinsätze 24, gegenüber der Umgebung des Gehäuses 10 wärmeisoliert, wobei die an den Seitenwänden 14, der Rückwand 18, Tür 16 und einer Oberseite 42 und Bodenseite 43 befestigten Isolationseinsätze 24 so bemessen sind, dass allenfalls ein äußerst geringer Wärmetransfer zwischen dem Innenraum 22 und der Umgebung des Gehäuses 10 auftritt.

In den Innenraum 22 des Gehäuses 10 ist ein Rahmen 26 eingesetzt, der als Aufnahmeebenen 28 insgesamt drei übereinander angeordnete Fachböden 28 aufweist, wobei jeder Fachboden 28 für jeweils vier Akkumulatoren 12 dient. Der Rahmen 26 und die Fachböden 28 sind vorzugsweise aus einem besonders wärmeleitfähigen Material, wie beispielsweise einer Stahllegierung gebildet. Um eine besonders gute Wärmeübertragung zwischen den Akkumulatoren 12 und den Fachböden 28 zu gewährleisten, können die Akkumulatoren 12 zusätzlich, beispielsweise durch Wärmeleitfolien, mit den Fachböden 28 wärmeleitend verbunden sein.

Zwischen der Rückwand 18 des Gehäuses 10 und dem im Innenraum 22 angeordneten Rahmen 26 sind insgesamt drei Peltierelemente 30 als Wärmetransfereinrichtungen 30 angeordnet. Jedes Peltierelement 30 ist in eine entsprechende Aufnahmeöffnung 32 im rückwärtigen Isolationseinsatz 24a eingesetzt. Die Aufnahmeöffnungen 32 sind so im rückwärtigen Isolationseinsatz 24a positioniert, dass jede Aufnahmeöffnung 32 sowohl vertikal als auch horizontal mittig zu jeweils einem der Fachböden 28 des Rahmens 26 ausgerichtet ist.

In die Aufnahmeöffnung 32 ist ferner zwischen jedem Fachboden 28 und dem diesen zugeordneten Peltierelement 30 ein Wärmeübertragungselement 34 eingesetzt, das das jeweilige Peltierelement 30 wärmeleitend mit dem Fachboden 28 verbindet. Des Weiteren ist zwischen dem in die Rückwand 18 integrierten Wärmetauscher 20 und dem jeweiligen Peltierelement 30 ein weiteres Wärmeübertragungselement 36 in die Aufnahmeöffnung 32 eingesetzt, das das Peltierelement 30 wärmeleitend mit dem Wärmetauscher 20 verbindet. Die Wärmeübertragungselemente 34 und 36 sind aus einem besonders wärmeleitfähigen Werkstoff.ausgebildet. Als Werkstoff für die Wärmeübertragungselemente 34 und 36 eignet sich beispielsweise Kupfer, Aluminium, Magnesium oder eine Legierung aus einem dieser Metallwerkstoffe.

Der an der Rückwand 18 vorgesehene Wärmetauscher 20 weist einen Nadelrippenrekuperator 38 auf, der in einem an der Rückwand 18 ausgebildeten Strömungskanal 40 des Wärmetauschers 20 angeordnet ist. Am oberen Ende des Strömungskanals 40 nahe der Oberseite 42 des Gehäuses 10 sind im Strömungskanal 40 zwei Fördereinrichtungen 24, z.B. Axialstromlüfter 44, angeordnet, von denen aus Darstellungsgründen in Fig. 1 nur einer zu erkennen ist. Bei Betrieb saugen die Axialstromlüfter 44 Luft von außen in den Strömungskanal 40 ein, welche entlang des Nadelrippenrekuperators 38 durch den Strömungskanal 40 gefördert wird und am unteren Ende des Strömungskanals 40 aus Austrittsöffnungen 46 austritt.

Nachfolgend wird die Funktionsweise des Gehäuses 10 näher erläutert.

Bei den im Gehäuse 10 angeordneten Akkumulatoren 12 handelt es sich beispielsweise um Hochleistungsakkumulatoren, die in einem vorgegebenen Temperaturbereich von 15 bis 25°C betrieben werden müssen. Sollte die Betriebstemperatur der Akkumulatoren 12 ständig um 10°C über der maximal zulässigen Betriebstemperatur von 25°C liegen, halbiert sich die Lebenszeit der Akkumulatoren 12, während Betriebstemperaturen von über 45°C zu einem Ausfall der Akkumulatoren 12 führen. Liegen dagegen die Betriebstemperaturen der Akkumulatoren 12 unter dem vorgegebenen minimal zulässigen Temperaturwert von 15°C, verringert sich die Ladekapazität der Akkumulatoren 12, so dass zusätzliche Akkumulatoren 12 vorgehalten werden müssten. Um die Akkumulatoren 12 im Gehäuse 10 innerhalb des zulässigen Temperaturbereiches von 15 bis 25°C betreiben zu können, kann die Temperatur im Innenraum 22 des Gehäuses 10 mit Hilfe der Peltierelemente 30 geregelt werden, wie nachfolgend erläutert wird.

Fällt die Temperatur in der Umgebung des Gehäuses 10 so weit ab, dass die Temperatur im Innenraum 22 unter den minimal zulässigen Temperaturwert von 15°C fällt, wird die Unterschreitung des minimal zulässigen Temperaturwertes von einer nicht dargestellten Steuerung erfasst, die die Temperatur im Innenraum 22 misst. In diesem Fall aktiviert die Steuerung die mit ihr in Verbindung stehenden Peltierelemente 30, während sie gleichzeitig die Axialstromlüfter 44 deaktiviert, sofern diese noch in Betrieb sind. Die Peltierelemente 30 werden dabei so geschaltet, dass sie sich erwärmen und die entstehende Wärmemenge größtenteils durch die Wärmeübertragungselemente 34 an die Fachböden 28 abgeben. Da die Fachböden 28 ihrerseits wärmeleitend mit den Akkumulatoren 12 verbunden sind, erwärmen sich diese, während sich gleichzeitig der Rahmen 26 den Innenraum 22 auf die gewünschte Innenraumtemperatur erwärmt. Auf diese Weise ist es möglich, den durch die niedrige Umgebungstemperatur verursachten Wärmeverlust des Innenraums 22 des Gehäuses 10 auszugleichen und die Akkumulatoren 12 innerhalb des vorgegebenen Temperaturbereiches zu betreiben.

Sollte dagegen die Temperatur im Innenraum 22 des Gehäuses 10, beispielsweise während des Ladens der Akkumulatoren 12 oder verursacht durch vergleichsweise hohe Temperaturen der Umgebung des Gehäuses 10, soweit ansteigen, dass sie über dem maximal zulässigen Temperaturwert von 25°C liegt, schaltet die Steuerung die Peltierelemente 30 so, dass sie die mit diesen wärmeleitend verbundenen Fachböden 28 abkühlen und die aufgenommene Wärme durch die weiteren Wärmeübertragungselemente 36 an den Nadelrippenrekuperator 38 des Wärmetauschers 20 abgeben. Sollte die Kühlleistung des Nadelrippenrekuperators 38 nicht ausreichen, werden zusätzlich die Axialstromlüfter 44 angeschaltet, die Kühlluft in den Strömungskanal 40 zum Kühlen des Nadelrippenrekuperators 38 ansaugen.

Sobald die Temperatur im Innenraum 22 des Gehäuses 10 wieder auf den gewünschten Temperaturwert abgesunken ist, deaktiviert die Steuerung die Peltierelemente 30 und die Axialstromlüfter 44.

Durch Verwendung der Peltierelemente 30 in Verbindung mit einem Wärmetauscher 20 mit wenigstens einem Strömungskanal 40 kann der Innenraum 22 des erfindungsgemäßen Gehäuses 10 sehr schnell abgekühlt oder erwärmt werden, so dass eine Fehlfunktion der Akkumulatoren 12 durch eine zu hohe oder zu niedrige Betriebstemperatur in einfacher Weise verhindert werden kann. Bei dem beschriebenen Ausführungsbeispiel wird ein Wärmetauscher 20 verwendet, dessen Nadelrippenrekuperator 38 mit Luft gekühlt wird. Es ist auch denkbar, als Kühlmedium Wasser oder eine andere Flüssigkeit zu verwenden, die eine entsprechend hohe Kühlleistung besitzt. Ferner ist es möglich, den Innenraum 22 durch die Fachböden 28 so zu trennen, dass allenfalls ein geringfügiger Wärmeaustausch zwischen einzelnen, von den Fachböden 28 gebildeten Kammern auftritt und jedes Peltierelement 30 jede einzelne Kammer des Innenraums 22 separat erwärmen oder auch abkühlen kann.

Des Weiteren kann für mehrere Peltierelemente 30 jeweils mindestens ein gemeinsames Wärmeübertragungselement 34 mit den Fachböden 28 thermisch gekoppelt sein, um den Rahmen 26 mit den Fachböden 28 auf die gewünschte Temperatur zu erwärmen bzw. abzukühlen.

## Patentansprüche

1. Gehäuse zur Aufnahme mindestens einer Energiespeichereinrichtung, insbesondere Batterieschrank, mit mindestens einer Wärmetransfereinrichtung (30) zur Temperaturregelung eines Gehäuseinnenraums (22) auf ein vorgegebenes Temperaturniveau, bei welchem der Gehäuseinnenraum (22) wärmeisoliert ist, die Wärmetransfereinrichtung (30) in direkter Wärmeleitverbindung mit dem Gehäuseinnenraum steht und bei geschlossenem Gehäuseinnenraum (22) der gesamte Wärmestrom in den und aus dem Gehäuseinnenraum (22) durch die Wärmetransfereinrichtung (30) erfolgt, wobei im Bereich einer Gehäusewand (18) ein Wärmetauscher (20) vorgesehen und die Wärmetransfereinrichtung (30) mit dem Wärmetauscher (20) wärmeleitend verbunden ist,
**dadurch gekennzeichnet,**
**dass** der Wärmetauscher (20) einen Nadelrippenrekuperator (38) aufweist, der in einem Strömungskanal (40) des Wärmetauschers (20) angeordnet ist, und
**dass** der Wärmetauscher (20) mindestens eine Fördereinrichtung (44) zum Fördern eines Kühlmediums durch den Strömungskanal (40) aufweist.

2. Gehäuse nach Anspruch 1,
**dadurch gekennzeichnet,**
**dass** die Nadelrippenstruktur des Nadelrippenrekuperators (38) in die Gehäusewand (18) integriert ist.

3. Gehäuse nach einem der Ansprüche 1 oder 2,
**dadurch gekennzeichnet,**
**dass** der Wärmetauscher (20) einen mit der Wärmetransfereinrichtung (30) wärmeleitend in Verbindung stehenden Nadelrippenrekuperator (38) aufweist.

4. Gehäuse nach einem der vorhergehenden Ansprüche,
**dadurch gekennzeichnet,**
**dass** die Fördereinrichtung (44) ausgeschaltet ist, wenn die Wärmetransfereinrichtung (30) den Gehäuseinnenraum (22) aufwärmt.

5. Gehäuse nach einem der vorhergehenden Ansprüche,
**dadurch gekennzeichnet,**
**dass** als mindestens eine Fördereinrichtung ein Axialstromlüfter (44), angeordnet ist.

6. Gehäuse nach einem der vorhergehenden Ansprüche,
**dadurch gekennzeichnet,**
**dass** die Wärmetransfereinrichtung (30) in der Isolierung (24) des Gehäuses (10) angeordnet ist.

7. Gehäuse nach einem der vorhergehenden Ansprüche,
**dadurch gekennzeichnet,**
**dass** die Wärmetransfereinrichtung (30) mit einem im Gehäuseinnenraum (22) vorgesehenen Rahmen (26) wärmeleitend verbunden ist, auf dem die Energiespeichereinrichtung (12) anzuordnen ist.

8. Gehäuse nach einem der vorhergehenden Ansprüche,
**dadurch gekennzeichnet,**
**dass** die Wärmetransfereinrichtung (30) mit Hilfe eines Wärmeübertragungselementes (34) mit dem Gehäuseinnenraum (22) wärmeleitend verbunden ist.

9. Gehäuse nach einem der vorhergehenden Ansprüche,
**dadurch gekennzeichnet,**
**dass** die Wärmetransfereinrichtung (30) mit dem Wärmetauscher (20) durch ein weiteres Wärmeübertragungselement (36) wärmeleitend verbunden ist.

10. Gehäuse nach Anspruch 8 oder 9,
**dadurch gekennzeichnet,**
**dass** das Wärmeübertragungselement (34) und/oder das weitere Wärmeübertragungselement (36) aus einem Werkstoff gebildet sind bzw. ist, der eine hohe Wärmeleitfähigkeit λ besitzt.

11. Gehäuse nach einem der vorhergehenden Ansprüche,
**dadurch gekennzeichnet,**
**dass** das Gehäuse (10) mehrere Ebenen (28) zur Aufnahme mindestens einer Energiespeichereinrichtung (12) aufweist und
**dass** jeder Ebene (28) mindestens eine Wärmetransfereinrichtung (30) zugeordnet ist.

12. Gehäuse nach einem der vorhergehenden Ansprüche,
**dadurch gekennzeichnet,**
**dass** das Gehäuse (10) mehrere Ebenen (28) zur Aufnahme mindestens einer Energiespeichereinrichtung (12) aufweist,
**dass** mindestens zwei der Ebenen (28) durch mindestens ein Wärmeübertragungselement (34) wärmeleitend verbunden sind und
**dass** das Wärmeübertragungselement (34) mit der Wärmetransfereinrichtung (30) thermisch gekoppelt ist.

13. Gehäuse nach.einem der vorhergehenden Ansprüche,
**dadurch gekennzeichnet,**
**dass** die Wärmetransfereinrichtung als Peltierelement (30) ausgebildet ist.

14. Gehäuse nach einem der vorhergehenden Ansprüche,
**dadurch gekennzeichnet,**
**dass** die Energiespeichereinrichtung (12) einen oder mehrere Akkumulator(en) (12) und/oder eine oder mehrere Batterie(n) aufweist.

## Claims

1. Casing for receiving at least one energy storage device, particularly a battery cabinet, with at least one heat transfer device (30) for regulating the temperature of a casing interior (22) to a predetermined temperature level, in which the casing interior (22) is thermally insulated, the heat transfer device (30) is in direct heat conducting connection with the casing interior and during the casing interior (22) being closed, the entire heat flow into and out of the casing interior (22) takes place through the heat transfer device (30) and in the area of a casing wall (18) is provided a heat exchanger (20) and the heat transfer device (30) is connected in heat conducting manner to the heat exchanger (20),
**characterized in that**
the heat exchanger (20) has a spine fin recuperator (38) located in a flow channel (40) of the heat exchanger (20) and
that the heat exchanger (20) has at least one delivery device (44) for the delivery of a cooling medium through the flow channel (40).

2. Casing according to claim 1,
**characterized in that**
the spine fin structure of the spine fin recuperator (38) is integrated into the casing wall (18).

3. Casing according to one of the claims 1 or 2,
**characterized in that**
the heat exchanger (20) has a spine fin recuperator (38) in heat conducting connection with the heat transfer device (30).

4. Casing according to one of the preceding claims,
**characterized in that**
the delivery device (44) is switched off if the heat transfer device (30) heats the casing interior (22).

5. Casing according to one of the preceding claims,
**characterized in that**
as at least one delivery device an axial flow fan (44) is provided.

6. Casing according to one of the preceding claims,
**characterized in that**
the heat transfer device (30) is located in the insulation (24) of the casing (10).

7. Casing according to one of the preceding claims,
**characterized in that**
the heat transfer device (30) is connected in heat conducting manner with a frame (26) located in the casing interior (22) and on which is to be placed the energy storage device (12).

8. Casing according to one of the preceding claims,
**characterized in that**
the heat transfer device (30) is connected in heat conducting manner to the casing interior (22) with the aid of a heat transmitting element (34).

9. Casing according to one of the preceding claims,
**characterized in that**
the heat transfer device (30) is connected in heat conducting manner to the heat exchanger (20) by a further heat transmitting element (36).

10. Casing according to claim 8 or 9,
**characterized in that**
the heat transmitting element (34) and/or the further heat transmitting element (36) is made from a material having a high thermal conductivity λ.

11. Casing according to one of the.preceding claims,
**characterized in that**
the casing (10) has several planes (28) for receiving at least one energy storage device (12) and
that with each plane (28) is associated at least one heat transfer device (30).

12. Casing according to one of the preceding claims,
**characterized in that**
the casing (10) has several planes (28) for receiving at least one energy storage device (12),
that at least two of the planes (28) are connected in heat conducting manner by at least one heat transmitting element (34) and
that the heat transmitting element (34) is thermally coupled to the heat transfer device (30).

13. Casing according to one of the preceding claims,
**characterized in that**
the heat transfer device is constructed as a Peltier element (30).

14. Casing according to one of the preceding claims,
**characterized in that**
the energy storage device (12) has one or more accumulators (12) and/or one or more batteries.

## Revendications

1. Boîtier destiné à recevoir au moins un dispositif d'accumulation d'énergie, en particulier une armoire à batteries, avec au moins un dispositif (30) de transfert de chaleur pour réguler la température de l'intérieur (22) du boîtier à un niveau de température prédéterminé, dans lequel l'intérieur (22) du boîtier est isolé thermiquement, le dispositif (30) de transfert de chaleur est en liaison conductrice de chaleur directe avec l'intérieur de boîtier et, quand l'intérieur (22) du boîtier est fermé, tout le flux de chaleur vers et depuis l'intérieur (22) du boîtier s'effectue à travers le dispositif (30) de transfert de chaleur, un échangeur de chaleur (20) étant prévu au niveau d'une paroi (18) du boîtier et le dispositif (30) de transfert de chaleur étant relié en conduction thermique à l'échangeur de chaleur (20),
***caractérisé en ce que*** l'échangeur de chaleur (20) présente un récupérateur (38) à aiguilles qui est placé dans un canal d'écoulement (40) de l'échangeur de chaleur (20), et
***en ce que*** l'échangeur de chaleur (20) présente au moins un dispositif de transport (44) pour transporter un fluide de refroidissement à travers le canal d'écoulement (40).

2. Boîtier selon la revendication 1,
***caractérisé en ce que*** la structure à aiguilles du récupérateur à aiguilles (38) est intégrée dans la paroi (18) du boîtier.

3. Boîtier selon l'une quelconque des revendications 1 ou 2,
***caractérisé en ce que*** l'échangeur de chaleur (20) comprend un récupérateur (38) à aiguilles en liaison conductrice thermique avec le dispositif (30) de transfert de chaleur.

4. Boîtier selon l'une quelconque des revendications précédentes,
***caractérisé en ce que*** le dispositif de transport (44) est arrêté quand le dispositif (30) de transfert de chaleur chauffe l'intérieur (22) du boîtier.

5. Boîtier selon l'une quelconque des revendications précédentes,
***caractérisé en ce que,*** comme dispositif de transport au nombre d'au moins un, il est prévu un ventilateur (44) à écoulement axial.

6. Boîtier selon l'une quelconque des revendications précédentes,
***caractérisé en ce que*** le dispositif (30) de transfert de chaleur est placé dans l'isolation (24) du boîtier (10).

7. Boîtier selon l'une quelconque des revendications précédentes,
***caractérisé en ce que*** le dispositif (30) de transfert de chaleur est relié en conduction thermique à un cadre (26) prévu dans l'intérieur (22) du boîtier, cadre sur lequel doit être placé le dispositif (12) d'accumulation d'énergie.

8. Boîtier selon l'une quelconque des revendications précédentes,
***caractérisé en ce que*** le dispositif (30) de transfert de chaleur est relié en conduction thermique avec l'intérieur (22) du boîtier au moyen d'un élément (34) de transmission de chaleur.

9. Boîtier selon l'une quelconque des revendications précédentes,
***caractérisé en ce que*** le dispositif (30) de transfert de chaleur est relié en conduction thermique avec l'échangeur de chaleur (20) par un autre élément (36) de transmission de chaleur.

10. Boîtier selon l'une quelconque des revendications 8 ou 9,
***caractérisé en ce que*** l'élément (34) de transmission de chaleur et/ou l'autre élément (36) de transmission de chaleur est/sont formé(s) d'un matériau qui présente une grande conductibilité thermique λ.

11. Boîtier selon l'une quelconque des revendications précédentes,
***caractérisé en ce que*** le boîtier (10) présente plusieurs niveaux (28) pour recevoir au moins un dispositif (12) d'accumulation d'énergie, et ***en ce qu***'à chaque niveau (28) est associé au moins un dispositif (30) de transfert de chaleur.

12. Boîtier selon l'une quelconque des revendications précédentes,
***caractérisé en ce que*** le boîtier (10) présente plusieurs niveaux (28) pour recevoir au moins un dispositif (12) d'accumulation d'énergie, ***en ce qu***'au moins deux des niveaux (28) sont reliés en conduction thermique par au moins un élément (34) de transmission de chaleur, et ***en ce que*** l'élément (34) de transmission de chaleur est couplé thermiquement au dispositif (30) de transfert de chaleur.

13. Boîtier selon l'une quelconque des revendications précédentes,
***caractérisé en ce que*** le dispositif de transfert de chaleur est conformé en élément (30) à effet Peltier.

14. Boîtier selon l'une quelconque des revendications précédentes,
***caractérisé en ce que*** le dispositif (12) d'accumulation d'énergie comprend un ou plusieurs accumulateur(s) (12) et/ou une ou plusieurs batterie(s).
